# EUROPEAN PATENT APPLICATION

(11) **EP 2 677 060 A1**
(43) Date of publication of application: **25.12.2013**
(21) Application number: 12747114.2
(22) Date of filing: 10.02.2012
(51) Int. Cl.: C23C 16/448, C23C 16/455

(54) **ATOMIC LAYER DEPOSITION APPARATUS AND ATOMIC LAYER DEPOSITION METHOD**

(30) Priority: 14.02.2011 JP 2011028623
(71) Applicant: Mitsui Engineering & Shipbuilding Co., Ltd., Chuo-ku Tokyo 104-8439 (JP)
(72) Inventor: MIYATAKE, Naomasa, Tamano-shi, Okayama 706-8651 (JP)
(74) Representative: Hards, Andrew
(86) International application number: PCT/JP2012/000915
(87) International publication number: WO 2012/111295

(57) **Abstract**

An atomic layer deposition apparatus that forms a thin film on a substrate, the atomic layer deposition apparatus includes: a deposition vessel in which a source gas supply port and a reactant gas supply port are formed; a source gas supply part operable to supply the source gas to the source gas supply port and that includes a liquid source storage part and a vaporization controller, the liquid source storage part storing a liquid source that is a source material of the thin film, and the vaporization controller controlling a flow rate by directly vaporizing the liquid source stored in the liquid source storage part; a reactant gas supply part operable to supply a reactant gas to the reactant gas supply port, the reactant gas reacting with the source gas to form the thin film; a controller operable to control the source gas supply part and the reactant gas supply part to supply the source gas and the reactant gas alternately; a screen plate that is disposed such that the source gas supplied from the source gas supply port collides therewith; and a temperature adjuster operable to adjust a temperature at the screen plate.

## Description

### Technical Field

The present invention relates to an atomic layer deposition apparatus and an atomic layer deposition method for forming a thin film on a substrate.

### Background Art

In forming a thin film on a substrate, there is well known Atomic Layer Deposition (ALD) method as a technique that is excellent in step coverage to evenly form the thin film (film-thickness controllability). In the ALD method, two kinds of gases mainly containing elements constituting the thin film to be formed, for example, a source gas and a reactant gas are alternately supplied to the substrate to form the thin film of an atomic layer on the substrate. In the ALD method, a self-limiting process of a reaction of the source gas on a substrate surface is used when the source gas is supplied to the substrate. The self-limiting process of the reaction on the substrate surface is a process in which, while the source gas is supplied, the source gas of only one or several layers adsorbs onto the substrate surface and the excess source gas does not adhere to the substrate surface and does not contributes to deposition. Therefore, the thin film having the desired film thickness can be formed by repeatedly forming the thin film of atomic layer on the substrate using the ALD method.

Compared with a general CVD (Chemical Vapor Deposition) method, the ALD method is excellent in step coverage and film-thickness controllability. Therefore, the ALD method is expected to be used in the formation of a capacitor of a memory element and an insulating film called a "high-k gate".
Additionally, in the ALD method, the insulating film can be formed at temperatures of 300°C or less. Therefore, the ALD method is expected to be used in the formation of a gate insulating film of a thin film transistor in a display device, in which a glass substrate is used, such as a liquid crystal display.

In the case that a source material used in the deposition is a liquid at ordinary temperatures and pressures, the liquid source is vaporized, and the thin film is formed using the vaporized source gas. A bubbling method and a baking method are well known as a method of vaporizing the liquid source. The bubbling method is a method in which the liquid in a supply cylinder is vaporized using bubbling of a carrier gas. In the bubbling method, the supply cylinder is heated to enhance a vapor pressure of the source gas, whereby the source gas is saturated in a bubbling carrier gas and supplied to a chamber. In the baking method, the liquid source is delivered into a heating tank to vaporize the source material, and a flow rate is controlled by a high-temperature mass flow controller.

Generally, in the case that the liquid source is vaporized to form the thin film using the vaporized source gas, in vaporizing the liquid source, the source gas contains not only a gas component of the liquid source but also a mist in which the liquid becomes a fine particle while the gas component and the mist are mixed in the source gas. When the mist is mixed in a deposition vessel, the mist adhering to an inner wall of the deposition vessel is liquefied and solidified with time, which causes generation of the particle.
Therefore, there is proposed a low-pressure CVD apparatus including a mist separator that separates the gas component of the liquid source from the mist and discharges the separated mist. There is a known low-pressure CVD apparatus (Patent Literature 1) described below.

### Citation List

### Patent Literature

Patent Literature 1: Japanese Patent Publication Laid-Open No. 2005-327864

### Summary of invention

### Technical Problem

Unlike the CVD method, in the ALD method, the pulsed source gas is supplied to the deposition vessel. In the case that the thin film is formed by the ALD method in which the bubbling method or baking method and the mist separator disclosed in Patent Literature 1 are used, the source gas that is vaporized when the pulsed supply of the source gas is off is not used but wasted, thereby decreasing use efficiency of the source material.
When the liquid source is vaporized in a short time of the supply of the source gas, namely, in the case that the liquid source is vaporized only when the pulsed supply of the source gas is on, the source gas may be insufficiently supplied when the pulsed supply of the source gas is on because it takes a time to stabilize a vaporization amount from the time when the vaporization is started.

An object of the present invention is to provide an atomic layer deposition apparatus and an atomic layer deposition method, which can improve the use efficiency of the liquid source and stably supply the pulsed source gas.

### Means to solve the problem

An aspect of the invention to solve the problem is an atomic layer deposition apparatus that forms a thin film on a substrate. The atomic layer deposition apparatus includes:
a deposition vessel in which a source gas supply port and a reactant gas supply port are formed;
a source gas supply part operable to supply the source gas to the source gas supply port and that includes a liquid source storage part and a vaporization controller, the liquid source storage part storing a liquid source that is a source material of the thin film, and the vaporization controller controlling a flow rate by directly vaporizing the liquid source stored in the liquid source storage part;
a reactant gas supply part operable to supply a reactant gas to the reactant gas supply port, the reactant gas reacting with the source gas to form the thin film;
a controller operable to control the source gas supply part and the reactant gas supply part to supply the source gas and the reactant gas alternately;
a screen plate that is disposed such that the source gas supplied from the source gas supply port collides therewith; and
a temperature adjuster operable to adjust a temperature at the screen plate.

The temperature adjuster preferably adjusts a temperature at the screen plate to a boiling point of the liquid source or more.

The vaporization controller is preferably a liquid injection valve.

The source gas supply part preferably includes a pressurization part that pressurizes the liquid source stored in the liquid source storage part.

Preferably, the source gas supply part includes a pressure sensing part that senses a pressure of the liquid source stored in the liquid source storage part, and the pressurization part pressurizes the liquid source to keep the pressure of the liquid source constant based on the pressure of the liquid source, which is sensed by the pressure sensing part.

The controller controls the source gas supply part to supply the source gas to an inside of the deposition vessel for supply time of 2 seconds or less.

Another aspect of the invention is an atomic layer deposition method for forming a thin film on a substrate. The atomic layer deposition method includes the steps of:
supplying a source gas to an inside of a deposition chamber to cause a component of the source gas to adhere to a substrate in the deposition chamber after the source gas collides with a screen plate, the source gas being obtained by vaporizing a liquid source; and
supplying a reactant gas to the inside of the deposition chamber after the component of the source gas is caused to adhere to the substrate, and causing the component of the source gas to react with the reactant gas to form a thin film layer on the substrate.
The screen plate is disposed such that the source gas collides therewith, and a temperature at the screen plate is adjusted to a boiling point of the liquid source or more.

### Advantageous Effect of Invention

According to the atomic layer deposition apparatus and atomic layer deposition method of the present invention, the use efficiency of the liquid source can be improved and the pulsed source gas can be stably supplied.

### Brief Description of Drawings

Fig. 1 is a schematic configuration diagram illustrating an example of an atomic layer deposition apparatus according to an embodiment.
Fig. 2 is a side view of an injector when the injector is viewed from a downstream direction in a flow of a source gas.
Fig. 3 is a flowchart illustrating an example of an atomic layer deposition method according to an embodiment.
Figs. 4A to 4B are views illustrating a process of forming a thin film on a substrate.

### Description of Embodiment

### [Embodiment]

### (Configuration of atomic layer deposition apparatus)

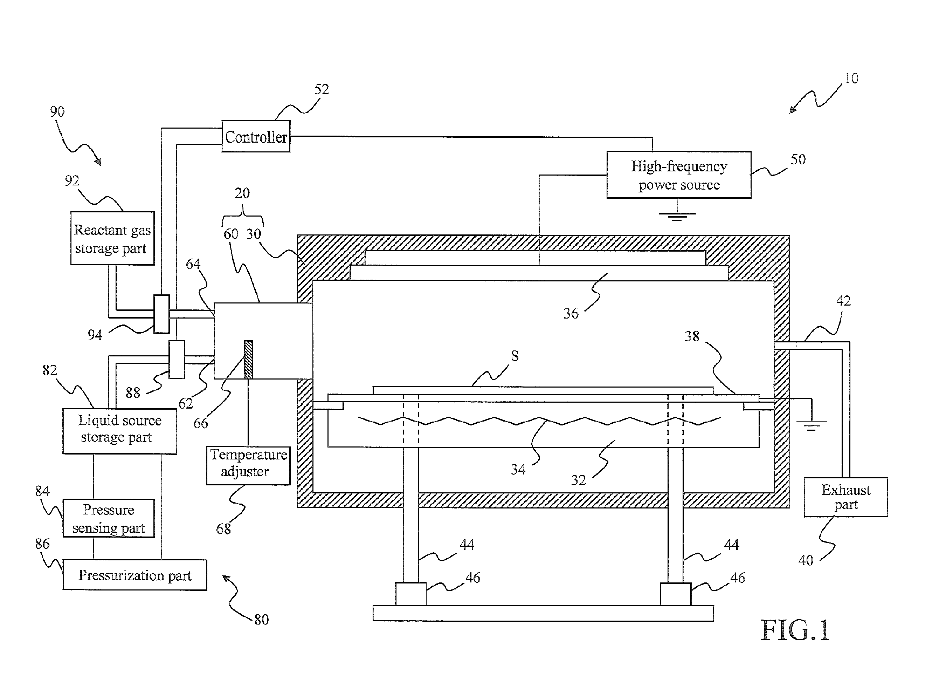

A configuration of an atomic layer deposition apparatus according to the embodiment will be described with reference to Fig. 1. Fig. 1 is a schematic configuration diagram illustrating an example of the atomic layer deposition apparatus of the embodiment. An atomic layer deposition apparatus 10 of the embodiment alternately supplies a source gas and a reactant gas to form a thin film of an atomic layer on a substrate S. The atomic layer deposition apparatus 10 enhances a reaction activity of the reactant gas with a component of the source gas adsorbing onto the substrate S, and thus it can generate plasma. In the embodiment, a parallel plate electrode is used to generate the plasma. However, the atomic layer deposition apparatus is not limited to the parallel plate electrode. In the embodiment, the thin film is formed using a source material that is in a liquid state at ordinary temperatures and pressures.
The atomic layer deposition apparatus 10 of the embodiment includes a deposition vessel 20, an exhaust part 40, a high-frequency power source 50, a controller 52, a source gas supply part 80, and a reactant gas supply part 90.

The deposition vessel 20 includes a vacuum chamber 30 and an injector 60.
The vacuum chamber 30 will be described below. The vacuum chamber 30 includes a support part 32, an upper electrode 36, and a lower electrode 38. The lower electrode 38 is provided on an upper surface of the support part 32. The lower electrode 38 is grounded. The substrate S is supported by lift pins 44 that pierce the support part 32 from under the vacuum chamber 30. The lift pins 44 can vertically be lifted and lowered by lifting and lowering mechanisms 46, and the lifting and lowering mechanisms 46 move the lift pins 44 downward while the lift pins 44 support the substrate S, thereby placing the substrate S on the lower electrode 38.
A heater 34 is provided in the support part 32, and the heater 34 can adjust a temperature at the substrate S.

The upper electrode 36 is provided above the substrate S, and connected to the high-frequency power source 50. The high-frequency power source 50 supplies a high-frequency current having a predetermined frequency to generate the plasma between the upper electrode 36 and the lower electrode 38.
The high-frequency power source 50 is connected to the controller 52. The controller 52 controls timing at which the high-frequency power source 50 supplies the high-frequency current to the upper electrode 36.

The injector 60 will be described below. The injector 60 is located on an upstream side in a flow of the source gas or reactant gas, which flows in the vacuum chamber 30. The injector 60 has an internal space, and a source gas supply port 62 that is horizontally long and narrow and a reactant gas supply port 64 that is horizontally long and narrow are formed in the internal space. A screen plate 66 that is horizontally long and narrow is provided in the internal space of the injector 60. The source gas is supplied from the source gas supply part 80 to the internal space of the injector 60 and the vacuum chamber 30 through the source gas supply port 62. The reactant gas is supplied from the reactant gas supply part 90 to the internal space of the injector 60 and the vacuum chamber 30 through the reactant gas supply port 64.

The screen plate 66 is disposed on a downstream side of the source gas supply port 62 in the flow of the source gas such that the source gas supplied from the source gas supply port 62 collides with the screen plate 66. The screen plate 66 is also disposed such that the reactant gas supplied from the reactant gas supply port 64 does not collide with the screen plate 66. That is, the screen plate 66 is provided face to face with the source gas supply port 62, and not face to face with the reactant gas supply port 64.
The screen plate 66 is connected to a temperature adjuster 68 that adjusts a temperature at the screen plate 66. Preferably the temperature adjuster 68 adjusts the temperature at the screen plate 66 to a boiling point of the liquid source or more. For example, preferably the screen plate 66 is adjusted at temperatures of 100°C to 200°C. In the embodiment, the screen plate 66 is adjusted at the temperature of 170°C.

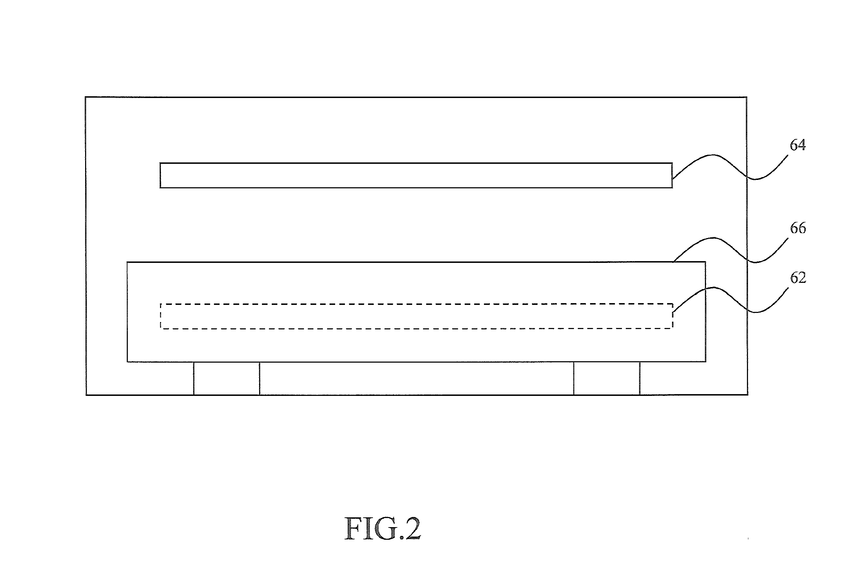

A positional relationship between the source gas supply port 62 and the screen plate 66 will be described with reference to Fig. 2. Fig. 2 is a side view of the injector 60 when the injector 60 is viewed from the downstream direction in the flow of the source gas. In the side view of Fig. 2, the screen plate 66 is disposed such that at least the source gas supply port 62 that is horizontally long and narrow overlaps completely with the screen plate 66. The reactant gas supply port 64 does not overlap with the screen plate 66. In the side view of Fig. 2, preferably the source gas supply port 62 is located in a position near the center in a height direction of the screen plate 66.

Referring again to Fig. 1, the exhaust part 40 exhausts the source gas, reactant gas, and purge gas, which are supplied to the vacuum chamber 30 through an exhaust pipe 42. For example, a dry pump is used as the exhaust part 40. Because the exhaust part 40 exhausts the vacuum chamber 30, a degree of vacuum inside the vacuum chamber 30 is maintained at about 10 Pa to about 100 Pa even if the source gas, reactant gas, and purge gas are supplied to the vacuum chamber 30.

The source gas supply part 80 will be described below. The source gas supply part 80 includes a liquid source storage part 82, a pressure sensing part 84, a pressurization part 86, and a vaporization controller 88.
The liquid source used to form the thin film is stored in the liquid source storage part 82. Examples of the liquid source stored in the liquid source storage part 82 include TEMAZ (tetrakis (ethylmethylamino) zirconium) and TEMAH (tetrakis (ethylmethylamino) hafnium).

The pressure sensing part 84 senses a pressure inside the liquid source storage part 82 in which the liquid source is stored. For example, the pressure sensing part 84 is a pressure meter. Data of the pressure sensed by the pressure sensing part 84 is transmitted to the pressurization part 86.
Based on the data of the pressure sensed by the pressure sensing part 84, the pressurization part 86 pressurizes the liquid source such that the pressure of the liquid source stored in the liquid source storage part 82 is kept constant. For example, the pressurization part 86 pressurizes the liquid source by delivering inert gas such as an N₂ gas and an Ar gas into the liquid source storage part 82.

The vaporization controller 88 controls a flow rate by directly vaporizing the liquid source, which was stored in the liquid source storage part 82 and has been supplied to the vaporization controller 88. For example, the vaporization controller 88 is a liquid injection valve. For example, an ALD liquid injection valve (product of Swagelok Company) can be used as the liquid injection valve.
The vaporization controller 88 is connected to the controller 52. The controller 52 controls timing at which the vaporization controller 88 vaporizes the liquid source. The vaporization controller 88 supplies the liquid source in a pulsed manner having lengths of 0.05 second to 2 seconds to directly vaporize the liquid source so that the vaporization controller 88 can supply the source gas. Sometimes the source gas generated by the vaporization controller 88 includes a mist, in which plural fine particles of the liquid source float in the liquid state.

The reactant gas supply part 90 will be described below. The reactant gas supply part 90 includes a reactant gas storage part 92 and a reactant gas valve 94.
The reactant gas used to form the thin film is stored in the reactant gas storage part 92. For example, the reactant gas stored in the reactant gas storage part 92 is oxidation gas such as an O₂ gas.
The reactant gas valve 94 is connected to the controller 52. The controller 52 controls opening and closing states of the reactant gas valve 94.

Although not illustrated, each of the source gas supply part 80 and the reactant gas supply part 90 is configured to be able to supply the purge gas such as the N₂ gas and the Ar gas to the inside of the deposition vessel 20.
The schematic configuration of the atomic layer deposition apparatus 10 of the embodiment is described above.

### (Atomic layer deposition method)

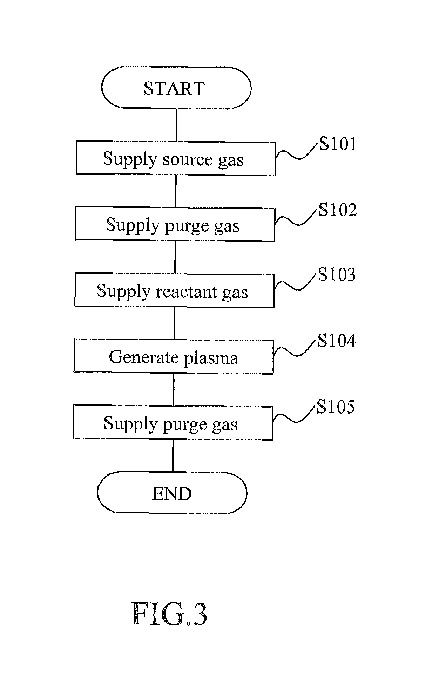

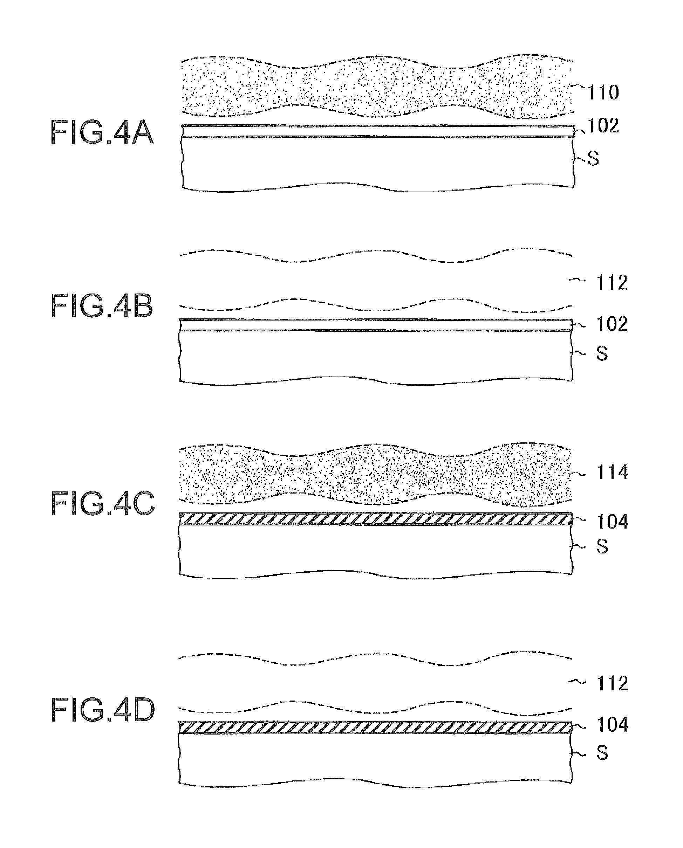

An atomic layer deposition method in which the atomic layer deposition apparatus 10 of the embodiment is used will be described below with reference to Figs. 3 and 4. Fig. 3 is a flowchart illustrating an example of the atomic layer deposition method of the embodiment. Figs. 4A to 4D are views illustrating a process of forming the thin film on the substrate S.

The source gas supply part 80 supplies the source gas to the inside of the deposition vessel 20 (Step S101).
In Step S 101, the pressure sensing part 84 senses the pressure in the liquid source storage part 82 in which the liquid source is stored, and the pressurization part 86 pressurizes the liquid source based on the data of the pressure sensed by the pressure sensing part 84 such that the pressure of the liquid source stored in the liquid source storage part 82 is kept constant. Therefore, the liquid source is supplied at a constant pressure from the liquid source storage part 82 to the vaporization controller 88 from the liquid source storage part 82.

The vaporization controller 88 directly vaporizes the liquid source supplied from the liquid source storage part 82, and the source gas is supplied from the source gas supply port 62 to the inside (the internal space of the injector 60) of deposition vessel 20 at the timing controlled by the controller 52. The vaporization controller 88 can incompletely vaporize the liquid source, and not only a gas component of the source material but also the mist is mixed in the source gas supplied from the source gas supply port 62.

The source gas, which has been supplied from the source gas supply port 62 while the gas component of the source material and the mist are mixed therein, collides with the screen plate 66 that is disposed on the downstream side of the source gas supply port 62 in the flow of the source gas. At this point, the mist supplied from the source gas supply port 62 is vaporized by colliding with the screen plate 66 because the temperature adjuster 68 adjusts the temperature at the screen plate 66 to the boiling point of the liquid source or more. Therefore, even if the vaporization controller 88 can incompletely vaporize the liquid source, the mist can be prevented from adhering to the inside of the deposition vessel 20.

For example, the source gas supply part 80 supplies the source gas to the inside of the deposition vessel 20 for 0.1 second. As illustrated in Fig. 4A, in Step S101, a gas component of source material 110 is supplied to the inside of the deposition vessel 20, and the gas component of source material (a component of the source gas) 110 adsorbs onto the substrate S to form an adsorption layer 102.

Then the source gas supply part 80 supplies a purge gas 112 to the inside of the deposition vessel 20 (Step S102). For example, the source gas supply part 80 supplies the purge gas 112 to the inside of the deposition vessel 20 for 0.1 second. The exhaust part 40 exhausts the gas component of source material 110 and the purge gas 112 in the deposition vessel 20. For example, the exhaust part 40 exhausts the gas component of source material 110 and the purge gas 112 in the deposition vessel 20 for 2 seconds. As illustrated in Fig. 4B, in Step S102, the purge gas 112 is supplied to the inside of the deposition vessel 20, and the gas component of source material 110, which has not adsorbed onto the substrate S due to a self-limiting process of a reaction on the surface of the substrate S, is purged from the deposition vessel 20.

Then the reactant gas supply part 90 supplies the reactant gas to the inside of the deposition vessel 20 (Step S103). The reactant gas valve 94 is opened at the timing controlled by the controller 52, and the reactant gas is supplied to the inside of the deposition vessel 20 from the reactant gas supply port 64. For example, the reactant gas supply part 90 supplies the reactant gas to the inside of the deposition vessel 20 for 1 second. As illustrated in Fig. 4C, in Step S103, a reactant gas 114 is supplied to the inside of the deposition vessel 20. At this point, the reactant gas does not collide with the screen plate 66 in the internal space of the injector 60, but is rapidly supplied to the inside of the vacuum chamber 30.

The high-frequency power source 50 supplies the high-frequency current having the predetermined frequency to the upper electrode 36 to generate the plasma between the upper electrode 36 and the lower electrode 38 (Step S104). For example, the high-frequency power source 50 generates the plasma of the reactant gas 114 for 0.2 seconds. The high-frequency power source 50 generates the plasma of the reactant gas 114, whereby an activated component of the reactant gas 114 reacts with the adsorption layer 102 to form a thin film layer 104.

The timing at which the high-frequency power source 50 generates the plasma of the reactant gas 114 may be identical to the timing at which the reactant gas supply part 90 supplies the reactant gas 114 to the inside of the deposition vessel 20.
Step S104 can be eliminated in the case that the reactant gas 114 reacts with the adsorption layer 102 without generating the plasma. In this case, the heater 34 heats the substrate S such that the reactant gas 114 reacts sufficiently with the adsorption layer 102.

Then the reactant gas supply part 90 supplies the purge gas 112 to the inside of the deposition vessel 20 (Step S105). For example, the reactant gas supply part 90 supplies the purge gas 112 to the inside of the deposition vessel 20 for 0.1 second. The exhaust part 40 exhausts the reactant gas 114 and the purge gas 112 in the deposition vessel 20. As illustrated in Fig. 4D, in Step S105, the purge gas 112 is supplied to the inside of the deposition vessel 20, and the reactant gas 114 is purged from the deposition vessel 20.

The thin film layer 104 of one atomic layer is formed on the substrate S through Steps S101 to S105. The thin film layer 104 having a desired film thickness can be formed by repeating Steps S101 to S105 predetermined times.

As described above, in the atomic layer deposition apparatus 10 and atomic layer deposition method of the embodiment, the screen plate 66 is disposed on the downstream side of the source gas supply port 62 in the flow of the source gas, and the temperature adjuster 68 adjusts the temperature at the screen plate 66. Therefore, the atomic layer deposition apparatus 10 and the atomic layer deposition method can prevent the mist from adhering to the inside of the deposition vessel 20 even if the vaporization controller 88 can incompletely vaporize the liquid source. As a result, the use efficiency of the liquid source can be improved and the pulsed source gas can be stably supplied. In particular, in the atomic layer deposition method in which the source gas is supplied to the inside of the deposition vessel 20 for supply time of 2 seconds or less, the source gas can quickly be generated from the liquid source and supplied to the deposition vessel 20. Therefore, the use efficiency of the liquid source is further improved.
In particular, the temperature adjuster 68 adjusts the temperature at the screen plate 66 to the boiling point of the liquid source or more so that the mist colliding with the screen plate 66 can surely be vaporized.
The liquid source in the liquid source storage part 82 is pressurized, so that the liquid source can effectively be supplied to the vaporization controller 88. The pressurization part 86 controls the pressurization of the liquid source at a constant level, so that a constant amount of source gas can always be supplied to the inside of the deposition vessel 20.
The source gas collides with the screen plate 66 while the reactant gas does not collide with the screen plate 66 because the screen plate 66 is not provided face to face with the front surface of the reactant gas supply port 64 but provided face to face with the front surface of the source gas supply port 62. Therefore, the reactant gas can rapidly be supplied to the vacuum chamber 30. Even if the liquid source is not vaporized in the screen plate 66 but adheres to the screen plate 66, the reactant gas does not collide with the screen plate 66. Therefore, the the thin film layer that causes the particle is prevented from being formed on the screen plate 66.
In the embodiment, the one screen plate 66 is provided in the injector 60. Alternatively, plural screen plates may be provided to more surely vaporize the mist. In this case, there is no particular limitation to the disposition of the screen plate. Preferably the screen plate is provided face to face with the source gas supply port 62 such that the source gas, which flows from the source gas supply port 62 while containing the mist, collides first with the screen plate.

Although the atomic layer deposition apparatus and atomic layer deposition method of the present invention are described above in detail, the present invention is not limited to the embodiment. Various changes and modifications can be made without departing from the scope of the present invention.

### Reference Signs List

- 10: atomic layer deposition apparatus
- 20: deposition vessel
- 30: vacuum chamber
- 32: support part
- 34: heater
- 36: upper electrode
- 38: lower electrode
- 40: exhaust part
- 42: exhaust pipe
- 44: lift pin
- 46: lifting and lowering mechanism
- 50: high-frequency power source
- 52: controller
- 60: injector
- 62: source gas supply port
- 64: reactant gas supply port
- 66: screen plate
- 68: temperature adjuster
- 80: source gas supply part
- 82: liquid source storage part
- 84: pressure sensing part
- 86: pressurization part
- 88: vaporization controller
- 90: reactant gas supply part
- 92: reactant gas storage part
- 94: reactant gas valve
- 102: adsorption layer
- 104: thin film layer
- 110: gas component of source material
- 112: purge gas
- 114: reactant gas
- S: substrate

## Claims

1. An atomic layer deposition apparatus that forms a thin film on a substrate, the atomic layer deposition apparatus comprising:
a deposition vessel in which a source gas supply port and a reactant gas supply port are formed;
a source gas supply part configured to supply the source gas to the source gas supply port and that includes a liquid source storage part and a vaporization controller, the liquid source storage part for storing a liquid source that is a source material of the thin film, and the vaporization controller configured to control a flow rate by directly vaporizing the liquid source stored in the liquid source storage part;
a reactant gas supply part configured to supply a reactant gas to the reactant gas supply port, the reactant gas reacting with the source gas to form the thin film;
a controller configured to control the source gas supply part and the reactant gas supply part to supply the source gas and the reactant gas alternately;
a screen plate disposed in such a manner that the source gas supplied from the source gas supply port collides therewith; and
a temperature adjuster configured to adjust a temperature at the screen plate.

2. The atomic layer deposition apparatus according to claim 1, wherein the temperature adjuster is configured to adjust the temperature at the screen plate to a boiling point of the liquid source or more.

3. The atomic layer deposition apparatus according to claim 1 or 2, wherein the vaporization controller is a liquid injection valve.

4. The atomic layer deposition apparatus according to any one of claims 1 to 3, wherein the source gas supply part includes a pressurization part that is configured to pressurize the liquid source stored in the liquid source storage part.

5. The atomic layer deposition apparatus according to claim 4, wherein
the source gas supply part includes a pressure sensing part that is configured to sense a pressure of the liquid source stored in the liquid source storage part, and
the pressurization part is configured to pressurize the liquid source to keep the pressure of the liquid source constant based on the pressure of the liquid source, which is sensed by the pressure sensing part.

6. The atomic layer deposition apparatus according to any one of claims 1 to 5, wherein the controller is configured to control the source gas supply part to supply the source gas to an inside of the deposition vessel for supply time of 2 seconds or less.

7. The atomic layer deposition apparatus according to any one of claims 1 to 6, wherein the screen plate is not provided face to face with a front surface of the reactant gas supply port but provided face to face with a front surface of the source gas supply port.

8. An atomic layer deposition method for forming a thin film on a substrate, the atomic layer deposition method comprising the steps of:
supplying a source gas to an inside of a deposition chamber to cause a component of the source gas to adhere to a substrate in the deposition chamber after the source gas collides with a screen plate, the source gas being obtained by vaporizing a liquid source; and
supplying a reactant gas to the inside of the deposition chamber after the component of the source gas is caused to adhere to the substrate, and causing the component of the source gas to react with the reactant gas to form a thin film layer on the substrate,
wherein
the screen plate is disposed in such a manner that the source gas collides therewith, and
the temperature at the screen plate is adjusted to a boiling point of the liquid source or more.
